# EUROPEAN PATENT APPLICATION

(11) **EP 3 986 098 A1**
(43) Date of publication of application: **20.04.2022**
(21) Application number: 20201830.5
(22) Date of filing: 14.10.2020
(51) Int. Cl.: H05K 7/14, H05K 5/06

(54) **SUBSEA DRIVE WITH INTEGRATED BREAKER**

(71) Applicant: ABB Schweiz AG, 5400 Baden (CH)
(72) Inventor: LENDENMANN, Heinz, 722 18 Västerås (SE); INGEBRIGTSEN, Stian, 5252 Bergen (NO); FUTANE, Pravin, 5097 Bergen (NO)
(74) Representative: Kransell & Wennborg KB

(57) **Abstract**

The present disclosure relates to a subsea drive system (10) comprising: a Variable Speed Drive, VSD, (1) arranged for outputting a current (Io) with variable frequency for controlling an electrical motor (11); a Main Circuit Breaker, MCB, (2) integrated with the VSD and arranged for being able to break an input current (Ii) to the VSD; a tank (3) filled with an electrically insulating liquid (4) and enclosing the VSD and MCB arranged in the electrically insulating liquid, the tank separating the VSD and MCB from ambient water (5); and a pressure compensator (6) arranged in a wall (3a) of the tank for, within a margin of error, maintaining an inside pressure (P*) in the electrically insulating liquid equal to an outside pressure (P) in the ambient water.

## Description

### TECHNICAL FIELD

The present disclosure relates to a subsea drive system comprising a Variable Speed Drive (VSD) arranged for outputting a current (Io) with variable frequency for controlling an electrical motor.

### BACKGROUND

Reliability is an important feature for subsea equipment, which are designed for long life with minimum need for maintenance or repair. Modular solutions are traditionally used, where small (and thus less heavy) parts (i.e. modules) of the equipment may be lifted ashore and serviced individually. However, the traditional way of implementing a power distribution and conversion system in redundant and reliable manner for subsea has become complex and expensive, especially for equipment with a high power rating e.g. above 100 kW. A reduction of cost is desired. A significant part of the system cost is attributed to the subsea high-voltage (HV) cable and connection systems which for an installation increase in number proportional to the number of power modules.

Subsea power consumers, such as Electrical Submersible Pumps (ESPs), seabed pumps and compressors are operated at variable supply frequency and variable voltage. VSDs are thus required in order to control the speed and the torque of the pump motors.

### SUMMARY

It has now been realized that by reducing interfaces between modules through a more integrated solution, reliability may be improved and cost saved.

According to an aspect of the present invention, there is provided a subsea drive system comprising a VSD arranged for outputting a current with variable frequency for controlling an electrical motor. The system also comprises an MCB integrated with the VSD and arranged for being able to break an input current to the VSD. The system also comprises a tank filled with an electrically insulating liquid and enclosing the VSD and MCB arranged in the electrically insulating liquid, the tank separating the VSD and MCB from ambient water. The system also comprises a pressure compensator arranged in a wall of the tank for, within a margin of error, maintaining an inside pressure in the electrically insulating liquid equal to an outside pressure in the ambient water.

By the MCB being integrated with the VSD, arranged within the same tank and at the same pressure, the number of pressure and/or water barriers within the system is reduced. Thus, fewer connection and conduit interfaces for passing such pressure and water barriers are needed, reducing the cost and complexity of the system. In addition to being physically integrated with the VSD, the MCB may be functionally integrated e.g. by being controlled by the VSD controller (though the MCB control may additionally or alternatively be by a separate controller e.g. taking other factors such as protection functions and interlocking into account).

By means of the pressure compensator, and by the tank being liquid-filled, the pressure within the tank can be maintained at or close to the ambient pressure, further reducing the pressure barriers within the system, and between the system and its surroundings, reducing the complexity and cost of the system in combination with the integration of the MCB.

In some embodiments of the present invention, the VSD controller is also integrated with the VSD, within or at the VSD tank. The controller may still need to be arranged in air and/or close to atmospheric pressure, but integration may e.g. remove a water barrier between the controller and the VSD tank by arranging the controller, typically held in a controller tank, within the tank or mounted directly to the outside of the VSD tank. Thus, the complexity and cost of the system may be further reduced.

It is to be noted that any feature of any of the aspects may be applied to any other aspect, wherever appropriate. Likewise, any advantage of any of the aspects may apply to any of the other aspects. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated. The use of "first", "second" etc. for different features/components of the present disclosure are only intended to distinguish the features/components from other similar features/components and not to impart any order or hierarchy to the features/components.

### BRIEF DESCRIPTION OF THE DRAWING

Embodiments will be described, by way of example, with reference to the accompanying drawing, in which:

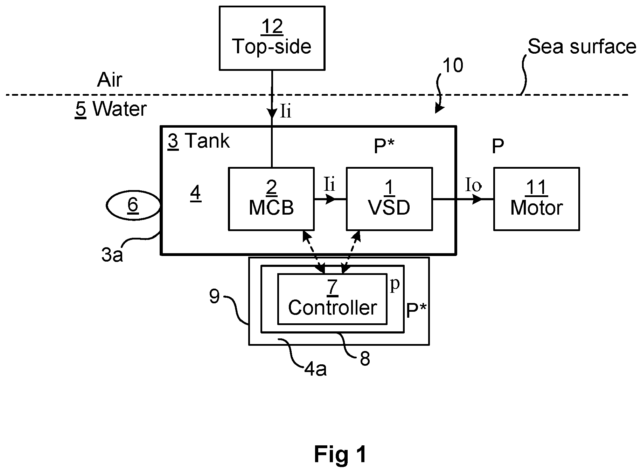

Fig 1 is a schematic block diagram of a subsea drive system in accordance with some embodiments of the present invention.

### DETAILED DESCRIPTION

Embodiments will now be described more fully hereinafter with reference to the accompanying drawings, in which certain embodiments are shown. However, other embodiments in many different forms are possible within the scope of the present disclosure. Rather, the following embodiments are provided by way of example so that this disclosure will be thorough and complete, and will fully convey the scope of the disclosure to those skilled in the art. Like numbers refer to like elements throughout the description.

Figure 1 illustrates a subsea drive system arranged in water 5 and connected to a top-side, e.g. on-shore or off-shore, electrical power system 12 in air above the (sea) surface of the body of water 5 in which the drive system 10 is arranged. The drive system 10 is arranged to receive an input electrical current Ii from the top-side power system 12 and output an output current Io to drive at least one load 11, typically including at least one electrical motor 11, e.g. for a compressor and/or pump such as an ESP, or a pipeline heater or heating load.

The subsea drive system 10 comprises at least one VSD 1 and an associated Main Circuit Breaker (MCB) 2, as well as a VSD controller 7. By means of the MCB 2 and controller 7, the system may operate substantially "stand alone", independently of e.g. top-side equipment or communication or any other hardware outside of the system 10 which may be integrated as a single unit (e.g. enclosed or welded together with the tank 3 thereof). For instance, there is no need for an external switchgear for distributing electrical power from the top-side grid since this function may be performed by the at least one MCB 2 which is integrated with the VSD 1 within the tank 3 in accordance with the present disclosure.

The MCB 2 is arranged for being able to break the input current Ii to the VSD, protecting the VSD 1 from fault currents, transients or the like of the input current. The MCB may have a rating of at least 6 kV and/or at least 100 A, e.g. within the range of 30-40 kV and/or 1500-2000 A. As mentioned, the MCB 2 is a circuit breaker with the capability to interrupt current Ii from a power grid supply line and should not be confused with other switches e.g. inside the VSD 1 such as disconnectors which are no-load switches, i.e. are unable to interrupt current, used for other functions inside the VSD.

The VSD 1 is arranged to provide the output current Io to the at least one electrical motor 11. In some embodiments, the VSD 1 is arranged to provide the output current Io with a maximum power of at least 0.5 MW, e.g. at least 1 MW or at least 5 MW. In some embodiments, the VSD 1 is arranged to provide the output current Io with a maximum power within the range of 0.5-20 MW, preferably within the range of 4-12 MW. A maximum power of about or at least 6 MW (or about or at least 11 MW, in some embodiments) enables powering of a complete range of subsea processing equipment, e.g. including subsea injection, boosting and gas compression and/or heating e.g. pipeline heating.

The controller 7 is typically arranged for controlling both the VSD 1 and the MCB 2, e.g. arranged for sending control signals to either or both of the VSD and MCB. The controller 7 may also be arranged for receiving sensor signals from either or both of the VSD and MCB. The controller may control the VSD and MCB by means of the control signals based on the sensor signals and/or based on external input e.g. from an operator such as a human operator (via a user interface) or an operating system. The controller 7 may comprise different control functions in the system 10, e.g. cell control, measurement control, MCB control, main control, and/or communication control etc. Some control functions not comprised in the controller 7 may be comprised elsewhere in the system 10. The VSD controller 7 may also comprise means for communication with the top-side 12. The VSD controller 7 may comprise, or be separate from, electronics hardware for control of the MCB 2.

The at least one VSD 1 and its associated MCB(s) 2 are contained in the same VSD tank 3 which is filled with an electrically insulating liquid 4, e.g. a transformer oil. In some embodiments, e.g. in case of high power ratings, the VSD function of the system 10 may be spread over a plurality of tanks 3, each tank comprising at least one (sub-) VSD and associated MCB(s) 2. The VSD and MCB are thus fully immersed in the liquid 4. The tank 3 holds the liquid 4 and prevents leakage of the liquid out of the tank and of the surrounding water 5 into the tank. Typically, the tank 3 is completely filled by the liquid 4, without any free interfaces with any pockets of air or water. Thus, the VSD 1 and its MCB 2 operates in the liquid 4 (though the MCB 2 may have internal parts in air, or other gas such as SF6, and/or vacuum), facilitating the use of so called pressure compensating, whereby the inside pressure P* inside the tank 3 is allowed to be the same as the outside pressure P of the surrounding water 5 directly outside of the tank (at the same water depth as the tank).

A pressure compensator 6 is arranged in a wall 3a of the tank 3 for maintaining the inside pressure P* equal (or close) to the outside pressure P. For instance, during operation of the drive system 10, heat may be formed which heats the liquid 4 which then expands. Similarly, the liquid 4 typically contracts when cooling down. Then, the pressure compensator 6 is needed for maintaining the inside pressure P* substantially constant and equal (or close) to the outside pressure P. Such pressure compensators 6 are known and may e.g. comprise a bellow and/or a diaphragm via which the liquid is allowed to expand when needed without much increasing the inside pressure P*. The inside pressure P* may be maintained equal to the outside pressure P to within a predetermined margin of error (or tolerance). In some embodiments, the margin of error is ±1 bar, but more preferably ±0.5 bar, of the outside pressure (P).

The tank 3 may, when operable, be at a depth of up to 5000 m, e.g. up to 3000 m, and/or of at least 10 m, e.g. at least 100 m. It follows that the outside pressure P, and consequently the inside pressure P*, may be hundreds of bar, e.g. up to 500 or 300 bar, and may be at least 2, 10 or 100 bar, e.g. within the range of 10-500 bar, such as within the range of 10-300 bar.

In contrast to the VSD 1 and MCB 2, the controller 7 typically needs to operate in air and typically at a pressure p which is substantially lower than the pressure P of the ambient water. Thus, the controller 7 is contained in a controller housing 8 able to separate the air inside the controller housing from the surrounding liquid (be it water or electrically insulating liquid) and able to maintain the lower pressure p. Typically, the controller pressure p is atmospheric or close to atmospheric pressure, e.g. within the range of 0.8-1.2 bar.

Preferably, the controller housing 8 is electrically insulated from its surroundings, e.g. from the ambient water 5, e.g. by means of an electrically insulating liquid 4a. In some embodiments, the controller 7 in its housing 8 is arranged within the tank 3, and thus immersed in the electrically insulating liquid 4. Alternatively, the controller 7 in its housing 8 is arranged within an outer housing 9 which is filled with the electrically insulated liquid 4a, which may be the same or different from the liquid 4 in the tank 3. The controller 3 may then be arranged outside of the tank 3 (as in the embodiment illustrated in figure 1), but in order to further reduce the complexity and number of water barriers within the drive system 10, the outer housing 9 is preferably mounted (fixed) to the outside of any of the walls 3a of the tank 3. The outer housing 9 may e.g. be welded to the outside of any of the walls 7 of the tank 3. The use of an outer housing 9 does not preclude that the controller, with its controller housing 8 and outer housing 9, may be arranged within the tank 3. Regardless, the outer housing 9 may be fixed within or to the tank 3, inside or outside of the tank, e.g. welded to the tank. Even if the controller 7 is arranged outside of the tank 3, it may be advantageous if the electrically insulating liquid 4a between the inner and outer housings 8 and 9 of the controller is in fluid (i.e. liquid) communication with the liquid 4 in the tank 3 (the liquids 4 and 4a then typically having the same composition). Pressure and heat etc. may then be equalized between the inside of the tank 3 and the inside of the outer housing 9. Thus a lower pressure p may be maintained within the controller housing 8 while a higher pressure P* (substantially the same as the inside pressure within the tank 3) may be maintained between the controller housing 8 and the outer housing 9, as in the embodiment illustrated in figure 1.

The VSD 1 may typically be used for driving at least one motor 11, e.g. a pump such as an ESP, but other possible uses include use as Uninterruptible Power Supply (UPS) or other general power supply functions, with single or multiple phases (e.g. three-phase systems, but not limited thereto). The at least one VSD 1 may comprise a plurality of VSDs, each associated with a respective MCB 2. In some embodiments there are only one VSD 1 per tank 3, but in some other embodiments two or more VSDs 1 may be contained in the same tank 3, e.g. for driving respective independent motors 11. In case of a plurality of VSDs 1 comprised in the same tank 3, each VSD may be connected via a respective MCB 2, or at least two (or all) of the VSDs in the same tank may be connected via the same (common) MCB. For example, a plurality of smaller (e.g. 0.5 MW) VSDs 1 may be connected via a common MCB or via respective MCBs (e.g. one MCB for each one, or each two, VSD). As mentioned above, in some embodiments, the VSD function of the system 10 may be spread over a plurality of VSDs 1 in a plurality of tanks 3, wherein VSDs in different tanks 3 may be connected via a respective MCB in each tank or via a communal MCB in one of the tanks.

The present disclosure has mainly been described above with reference to a few embodiments. However, as is readily appreciated by a person skilled in the art, other embodiments than the ones disclosed above are equally possible within the scope of the present disclosure, as defined by the appended claims.

## Claims

1. A subsea drive system (10) comprising:
a Variable Speed Drive, VSD, (1) arranged for outputting a current (Io) with variable frequency for controlling an electrical motor (11);
a Main Circuit Breaker, MCB, (2) integrated with the VSD and arranged for being able to break an input current (Ii) to the VSD;
a tank (3) filled with an electrically insulating liquid (4) and enclosing the VSD and MCB arranged in the electrically insulating liquid (4), the tank separating the VSD and MCB from ambient water (5); and
a pressure compensator (6) arranged in a wall (3a) of the tank for, within a margin of error, maintaining an inside pressure (P*) in the electrically insulating liquid equal to an outside pressure (P) in the ambient water.

2. The system of claim 1, wherein the pressure compensator (6) comprises a bellow and/or a diaphragm.

3. The system of any preceding claim, wherein the margin of error is ±1 bar, e.g. ±0.5 bar, of the outside pressure (P).

4. The system of any preceding claim, wherein the electrically insulating liquid (4) is a transformer oil.

5. The system of any preceding claim, wherein the VSD (1) is arranged to provide the output current (Io) with a maximum power of at least 0.5 MW or at least 4 MW, e.g. within the range of 0.5-20 MW, preferably within the range of 4-12 MW.

6. The system of any preceding claim, further comprising:
a controller (7) arranged in air at a controller pressure (p) which is below both of the inside and outside pressures (P*, P), within a controller housing (8).

7. The system of claim 6, wherein the controller pressure (p) is within the range of 0.8-1.2 bar, e.g. atmospheric pressure.

8. The system of claim 6 or 7, wherein the controller housing (8) is enclosed in an outer housing (9) filled with electrically insulating liquid (4a).

9. The system of claim 8, wherein the outer housing (9) is fixed within or to the tank (3), e.g. welded to the tank (3).

10. The system of claim 8 or 9, wherein the electrically insulating liquid (4a) of the outer housing (9) is in liquid communication with the electrically insulating liquid (4) of the tank (3).

11. The system of claim 6 or 7, wherein the controller housing (8) is arranged in the electrically insulating liquid (4) within the tank (3).

12. The system of any preceding claim, wherein the VSD (1) is one of a plurality of VSDs enclosed in the tank (3), each of the plurality of VSDs being connected via the MCB (2) or via a respective MCB (2) enclosed in the tank.

13. The system of any preceding claim, further comprising a second tank (3) enclosing a second VSD (1) which is connected via the MCB (2).
